(19) **Europäisches Patentamt**
**European Patent Office**
**Office européen des brevets**

(11) **EP 2 554 628 B1**

(12) **EUROPEAN PATENT SPECIFICATION**

(45) Date of publication and mention
of the grant of the patent:
**13.07.2016 Bulletin 2016/28**

(21) Application number: **11765354.3**

(22) Date of filing: **17.03.2011**

(51) Int Cl.:
**C09K 11/08** *(2006.01)*      **C09K 11/59** *(2006.01)*
**H01L 33/50** *(2010.01)*      **C09K 11/02** *(2006.01)*

(86) International application number:
**PCT/JP2011/056409**

(87) International publication number:
**WO 2011/125452 (13.10.2011 Gazette 2011/41)**

(54) **SURFACE-TREATED FLUORESCENT BODIES AND PROCESS FOR PRODUCTION OF SURFACE-TREATED FLUORESCENT BODIES**

OBERFLÄCHENBEHANDELTE FLUORESZIERENDE KÖRPER UND VERFAHREN ZUR HERSTELLUNG OBERFLÄCHENBEHANDELTER FLUORESZIERENDER KÖRPER

CORPS FLUORESCENTS TRAITÉS EN SURFACE ET PROCÉDÉ DE PRODUCTION DE CORPS FLUORESCENTS TRAITÉS EN SURFACE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2010 JP 2010083512**

(43) Date of publication of application:
**06.02.2013 Bulletin 2013/06**

(73) Proprietor: **Sekisui Chemical Co., Ltd.**
**Osaka-shi, Osaka 530-8565 (JP)**

(72) Inventors:
• **SUN, Ren-de**
**Mishima-gun,**
**Osaka 618-0021 (JP)**
• **NAKATANI, Yasuhiro**
**Mishima-gun**
**Osaka 618-0021 (JP)**
• **OOMURA, Takahiro**
**Mishima-gun**
**Osaka 618-0021 (JP)**

• **TANIKAWA, Mitsuru**
**Mishima-gun**
**Osaka 618-0021 (JP)**
• **WATANABE, Takashi**
**Mishima-gun**
**Osaka 618-0021 (JP)**

(74) Representative: **Hart-Davis, Jason et al**
**Cabinet Beau de Loménie**
**158, rue de l'Université**
**75340 Paris Cedex 07 (FR)**

(56) References cited:
**JP-A- 9 104 863        JP-A- 2002 539 925**
**JP-A- 2006 232 949    JP-A- 2008 111 080**
**JP-A- 2008 111 080    JP-A- 2009 132 902**
**JP-A- 2009 132 902    US-A1- 2003 173 540**
**US-A1- 2005 040 765  US-A1- 2007 001 585**
**US-A1- 2007 125 984**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a surface-treated phosphor having significantly enhanced moisture resistance, and a method for producing the surface-treated phosphor.

BACKGROUND ART

Semiconductor light-emitting elements (white LED) which emit white light have some advantages such as low electricity consumption, high efficiency, eco-friendliness, and long life. For this reason, much attention has been paid these days to semiconductor light-emitting elements as a next generation light source.

With regard to a method for generating white light from a white LED, generally a blue LED or a UV LED is combined with a phosphor (red phosphor, yellow phosphor, green phosphor, etc.) that can be excited by blue light or UV light.

A silicate phosphor containing an alkaline earth metal element has attracted attention due to the characteristics such as an ability to easily produce a wide range of emission wavelengths when the composition is controlled, and efficient light emission. Typical examples of such silicate phosphors include, in particular, a silicate phosphor having a structure of $(Sr,Ba,Ca)_2SiO_4:Eu^{2+}$ disclosed in Patent Document 1 and a silicate phosphor having a structure of $(Sr,Ba,Ca)_3SiO_5:Eu^{2+}$ disclosed in Patent Document 2. The emission wavelengths of the aforementioned silicate phosphors can be tuned by controlling the amount of Sr relative to the amount of Ba or Ca.

Problematically, however, the surface of the aforementioned silicate phosphor containing an alkaline earth metal element is easily decomposed and degraded by damp or moisture in the atmosphere. Thus, the light emission intensity tends to decrease and the color tone tends to be changed while the phosphor is used in the atmosphere for a long period of time, deteriorating the characteristics as phosphor. Therefore, the durability of the silicate phosphor is far from satisfactory.

In order to solve the problem, as a method to improve the moisture resistance of phosphors, a method has been examined in which surfaces of phosphor body particles are coated with an oxide or the like by a vapor phase technique (dry method), a liquid phase technique (wet method) or the like.

For example, as the method using a vapor phase technique, disclosed is a method for coating surfaces of sulfide phosphor particles with an aluminum oxide film using chemical vapor phase growth (CVD) technique (Patent Document 3) or plasma technique (Patent Document 4).

Examples of the method using a liquid phase technique include a sol-gel reaction method and a neutralization precipitation method. For example, Patent Document 5 discloses a method of surface-treating phosphor particles. The method includes a step of hydrolyzing an alkoxide of Si or Ti and/or its derivative in the presence of a large amount of ammonia water at a reaction temperature of 0°C to 20°C and polymerizing the same by dehydration. Patent Document 6 discloses a phosphor having a powder or a layer of Si-containing compound on the surface thereof.

Moreover, Patent Document 7 discloses a method of forming a zirconia film coat by sol-gel technique. Patent Document 8 discloses a method of precipitating a metal hydroxide on the surfaces of phosphor particles by dispersing phosphor particles in an alkali solution and then adding an acid solution containing ions such as aluminum into the alkali solution to cause a neutralization reaction.

However, in the vapor phase methods disclosed in Patent Documents 3 and 4, it is difficult to completely disperse the fine phosphor particles. Thus, it is practically difficult to uniformly coat the entire surface of each piece of the phosphor particles, and as a result, problems such as formation of a pinhole and uneven coating tend to occur. Further, since the vapor phase technique is normally performed at a high temperature of not lower than 400°C, problematically some kinds of phosphors significantly lose their fluorescence properties after the treatment. Moreover, because of the necessity of a large-scale apparatus, the production cost is high.

In the cases where sol-gel technique, a kind of liquid phase technique, is employed (Patent Documents 5, 6, and 7), a wide range of choices are available for the coating materials. However, normally a metal alkoxide as a starting material is highly reactive. For this reason, it is very difficult to control the reaction conditions for causing hydrolysis reaction only on the surfaces of the phosphor particles. Moreover, a film obtained by sol-gel technique contains organic components such as alkoxyl groups remaining due to incomplete hydrolysis or alcohol separated by hydrolysis. Therefore, it is usually difficult to obtain films having a dense structure.

Moreover, in a coating method disclosed in Patent Document 5, hydrolysis is performed in the presence of a large amount of ammonia water. Most of the materials are thus reacted and consumed not on the surface of phosphor body particles but in the solution, which is problematic in terms of reaction efficiency and cost. Further, the large amount of ammonia water used in the hydrolysis may deteriorate the phosphor body during the treatment.

In a method disclosed in Patent Document 6, a Si-containing compound, which is a coating material, is loaded on the surface of phosphor particles in a shape of a particle or a layer. However, practically this treatment produced almost no improvement in the moisture resistance. Moreover, under the reaction conditions disclosed in Examples in Patent Document 6, almost no coating reaction occurs on the surface of the phosphor particles. Therefore, in the case of the particle-shaped coating material, though partial coating is possible, it is difficult to efficiently block damp.

A method disclosed in Patent Document 7 needs a long-term reaction and precise control of the temperature and process, and thus has a problem in terms of the efficiency and cost.

According to a naturalization precipitation method disclosed in Patent Document 8, it is practically difficult to precipitate a coating material as a continuous film on the surface of phosphor particles.

Patent Document 1: Japanese Kohyo Publication 2009-515030 (JP-T 2009-515030) Patent Document 2: Japanese Kokai Publication 1997-104863 (JP-A 1997-104863) Patent Document 3: Japanese Kokai Publication 2001-139941 (JP-A 2001-139941) Patent Document 4: Japanese Kohyo Publication 2009-524736 (JP-T 2009-524736) Patent Document 5: Japanese Kokai Publication 2008-111080 (JP-A 2008-111080) Patent Document 6: Japanese Kokai Publication 2007-224262 (JP-A 2007-224262) Patent Document 7: Japanese Kokai Publication 2009-132902 (JP-A 2009-132902) Patent Document 8: Japanese Kokai Publication Hei-11-256150 (JP-A H11-256150) Document 9: JP2006232949 discloses a phosphor body with a surface treatment layer formed by metal fluoride complexes leading to a single layer containing titanium and /or silicon oxide.

SUMMARY OF INVENTION

PROBLEM TO BE SOLVED BY THE INVENTION

The present invention aims to provide a surface-treated phosphor having high dispersibility and capable of significantly enhancing moisture resistance without deteriorating the fluorescence properties, and a method for producing the surface-treated phosphor.

MEANS FOR SOLVING THE PROBLEM

The present invention relates to a surface-treated phosphor including a phosphor body; and a surface treatment layer containing at least one specific element selected from elements of the third to sixth groups of the periodic table, and fluorine, the phosphor body having the surface treatment layer on the surface thereof, wherein, when a cross section of the surface treatment layer is subjected to a thickness-wise elemental distribution analysis by a combination of an electron microscopic analysis and an energy-dispersive X-ray element analysis, a indicating the content of the specific element appears nearer to the surface than a indicating the fluorine content.

The present invention will be described in detail below.

As a result of extensive studies, the present inventors have found that a surface-treated phosphor having improved moisture resistance and high dispersibility without deteriorating the fluorescence properties can be obtained by forming a surface treatment layer containing a specific element and fluorine on the surface of a phosphor body under a condition where locations of peaks measured with an energy-dispersive X-ray element analyzer satisfy a predetermined requirement. Accordingly, the present inventors completed the present invention.

The surface-treated phosphor of the present invention includes a phosphor body and a surface treatment layer. The surface treatment layer contains at least one specific element selected from elements of the third to sixth groups of the periodic table, and fluorine.

The surface treatment layer contains the specific element and fluorine.

The fluorine contained in the surface treatment layer can prevent the phosphor body from being degraded by water in a coating treatment. In general, in the case of treating a phosphor body vulnerable to moisture, use of an aqueous solution is likely to be avoided. In the present invention, formation of the surface treatment layer makes it possible to perform a coating treatment in an aqueous solution. As a result, problems arising from use of an organic solvent such as waste liquid disposal do not occur.

Moreover, the formed surface treatment layer containing fluorine can enhance the moisture resistance of the surface-treated phosphor in use. The surface treatment layer has a higher stability in water than a silicate phosphor, which contributes to the enhancement of the moisture resistance in use.

Moreover, the specific element included in the surface-treatment layer improves a long-term moisture resistance. This is considered because an oxide of the specific element is stable.

Further, the surface treatment layer containing only fluorine has the following problem: A chemical bond of a fluoride is basically an ionic bond, and thus the dissociation tendency of a fluoride is higher than that of a covalent oxide. Therefore, if the surface-treated phosphor is used for a long time in the presence of humidity or moisture, hydrolysis of the alkaline earth metal in the fluoride may progress gradually. Therefore, sufficient long-term stability may not be achieved.

In contrast, by adding the specific element in addition to fluorine, an oxide layer having a higher stability in water is formed. Thereby, the resulting surface-treated phosphor can be provided with an excellent moisture resistance in long-term use.

The specific element is at least one selected from elements of the third to sixth groups of the periodic table, and is preferably one selected from elements of the fourth and fifth groups of the periodic table. Specifically, the specific element is preferably zirconium, titanium, hafnium, niobium, vanadium, or tantalum, or may be a combination of these elements.

In the surface treatment layer, the specific element is preferably present in an oxide state. Examples of the oxide of the specific element include zirconium oxide, titanium oxide, hafnium oxide, niobium oxide, vanadium oxide and tantalum oxide. Among the examples, zirconium oxide and titanium oxide are particularly preferable.

The preferable lower limit of the amount of the specific element in the surface treatment layer is preferably 5.0% by weight, and the preferable upper limit thereof is 85% by weight. If the amount of the specific element is less than 5.0% by weight, the long-term stability of the moisture resistance may be insufficient. If the amount exceeds 85% by weight, the fluorescence properties of the surface-treated phosphor may be deteriorated.

In the surface treatment layer, the fluorine is preferably present in a state of a fluoride of an alkaline earth metal formed of an alkaline earth metal and fluorine ion.

Examples of the fluoride of an alkaline earth metal include layers formed of strontium fluoride, barium fluoride, calcium fluoride, or magnesium fluoride. Among the examples, strontium fluoride and calcium fluoride are particularly preferable.

The preferable lower limit of the amount of the fluorine in the surface treatment layer is 1.0% by weight, and the preferable upper limit thereof is 60% by weight. If the amount of the fluorine is less than 1.0% by weight, the phosphor body may not be fully prevented from being decomposed and degraded by water in the coating treatment. If the amount exceeds 60% by weight, the long-term stability of the moisture resistance may be insufficient.

The thickness of the surface treatment layer is preferably 0.5 to 5000 nm, more preferably 1.0 to 3000 nm, further preferably 5.0 to 1000 nm, and particularly preferably 10 to 500 nm. If the thickness of the surface treatment layer is too small, the moisture resistance may be insufficient, and if too large, the fluorescence properties of the surface-treated phosphor may be deteriorated.

When a cross section of the surface treatment layer of the surface-treated phosphor of the present invention is subjected to a thickness-wise elemental distribution analysis by a combination of an electron microscopic analysis and an energy-dispersive X-ray element analysis, a peak indicating the maximum content of the specific element appears nearer to the surface than a peak indicating the maximum fluorine content.

The term "a combination of an electron microscopic analysis and an energy-dispersive X-ray element analysis" used herein refers to, for example, an analysis using an apparatus such as SEM-EDS (Scanning Electron Microscopy/Energy Dispersive Spectroscopy) or TEM-EDS (Transmission Electron Microscopy/Energy Dispersive Spectroscopy).

In the present invention, in also the case where a plurality of "peaks indicating the maximum content of the specific element" or a plurality of "peaks indicating the maximum fluorine content" exist, the condition of "peak indicating the maximum content of the specific element" appearing nearer to the surface than the "peak indicating the maximum fluorine content" is satisfied.

In the present invention, in the case where the "peak indicating the maximum content of the specific element" and "peak indicating the maximum fluorine content" satisfy the above conditions, it is possible to prevent the phosphor body from being decomposed and degraded by water in the coating treatment. Also, an excellent moisture resistance can be imparted to the surface-coated phosphor after the coating treatment.

In the present invention, preferably, the surface treatment layer is a single layer, and also fluorine is detected at a peak indicating the maximum content of the specific element in the thickness-wise elemental distribution analysis of the cross section of the surface treatment layer. In this case, the phosphor after the coating treatment has a higher affinity to a sealing resin so that the phosphor is better dispersed in the sealing resin.

Further, the preferable lower limit of the fluorine content at the peak indicating the maximum content of the specific element is 0.01% by weight, and the preferable upper limit thereof is 30% by weight.

In the element distribution in the thickness-wise direction of the cross section of the surface treatment layer, the preferable lower limit of the amount of the specific element at the peak indicating the maximum content of the specific element is preferably 1.0% by weight, and the preferable higher limit thereof is 75% by weight. By setting the amounts within the above ranges, a phosphor which is little deteriorated in a long-term use can be obtained.

Moreover, in the element distribution in the thickness-wise direction of the cross section of the surface treatment layer, the preferable lower limit of the fluorine content at the peak indicating the maximum fluorine content is 0.1% by weight, and the preferable upper limit thereof is 50% by weight. By setting the amounts within the above ranges, the phosphor body can be prevented from being decomposed and degraded by water in the coating treatment. Furthermore, an excellent moisture resistance can be imparted to the surface-coated phosphor after the coating treatment.

Meanwhile, the surface treatment layer is preferably a single layer. This is, for example, proved by curves of the amount of the specific element and fluorine in the energy-dispersive X-ray elemental analysis, the curve showing continuous gradual increase or gradual decrease at portions other than the peak portion, with no radical change in the content due to the interlayer boundaries. This configuration greatly contributes to the adhesiveness of the surface treatment layer. The problem of interlayer peeling is less likely to occur as compared with a configuration laminated by a mechanical method.

Moreover, the surface treatment layer may include a fluoride layer and an oxide layer containing an oxide of the specific element, in said order towards an outermost surface.

Generally, in the case of treating a phosphor body that is vulnerable to moisture, an aqueous solution tends not to be used. Formation of the fluoride layer makes it possible to perform a coating treatment in an aqueous solution so that problems such as waste liquid disposal can be avoided. Also, the moisture resistance of the coated product in use can be improved. Moreover, the oxide layer formed can further enhance the moisture resistance, thereby achieving long-term stability.

Accordingly, an excellent moisture resistance in a long-term use can be achieved by coating the fluoride layer with the oxide layer that is more stable in water.

The fluoride layer is preferably formed of a fluoride of an alkaline earth metal containing an alkaline earth metal and fluorine ion.

Examples of the fluoride layer include layers formed of strontium fluoride, barium fluoride, calcium fluoride, or magnesium fluoride. Among the examples, a layer formed of strontium fluoride or calcium fluoride is preferable.

The preferable lower limit of the amount of the fluoride in the fluoride layer is 5% by weight, and the preferable upper limit thereof is 95% by weight. If the amount of the fluoride is less than 5% by weight, the phosphor body is not completely prevented from being decomposed and degraded by water in the coating treatment. An amount exceeding 95% by weight may have a negative influence on the fluorescence properties of the phosphor.

The thickness of the fluoride layer is not particularly limited, and is generally preferably 0.5 to 5000 nm, more preferably 1 to 2000 nm, and further preferably 5 to 1000 nm. If the thickness of the surface treatment layer is too small, the effect of preventing degradation by water may be insufficient. An excessively large thickness of the surface treatment layer may have a negative influence on the fluorescence properties of the phosphor.

The oxide layer preferably includes, for example, zirconium oxide, titanium oxide, hafnium oxide, niobium oxide, vanadium oxide, tantalum oxide, or a compound thereof. Among the examples, zirconium oxide and titanium oxide are preferable.

The preferable lower limit of the amount of the oxide in the oxide layer is preferably 10% by weight, and the preferable upper limit thereof is 95% by weight. If the amount of the oxide is less than 10% by weight or more than 95% by weight, a long-term stability of the moisture resistance may be insufficient.

The thickness of the oxide layer is not particularly limited, and is generally preferably 0.5 to 5000 nm, more preferably 1.0 to 3000 nm, and further preferably 5.0 to 1000 nm. If the thickness of the oxide layer is too small, the degradation-preventing effect may be insufficient. An excessively large thickness of the oxide layer may have a negative influence on the fluorescence properties of the phosphor.

The phosphor body used in the surface-treated phosphor of the present invention is preferably a phosphor body containing an alkaline earth metal element. Examples of the phosphor body containing an alkaline earth metal include a sulfide-type phosphor body, an aluminate-type phosphor body, a nitride-type phosphor body, an oxynitride-type phosphor body, a phosphate-type phosphor body, a halophosphate-type phosphor body, and a silicate phosphor body.

Among the exemplified phosphor bodies, a silicate phosphor body containing an alkaline earth metal element is preferable.

Examples of the silicate phosphor body containing an alkaline earth metal element include a phosphor body having a host crystal structure that is practically the same structure as that of the crystal structure of $M_3SiO_5$ or $M_2SiO_4$ (M represents at least one selected from the group consisting of Mg, Ca, Sr, and Ba), and also having at least one dopant selected from the group consisting of Fe, Mn, Cr, Bi, Ce, Pr, Nd, Sm, Eu, Tb, Dy, Ho, Er, Tm, and Yb. The term "practically the same structure as that of the crystal structure of $M_3SiO_5$ or $M_2SiO_4$" used herein refers to a structure showing a similar X-ray diffraction pattern as that of $M_3SiO_5$ or $M_2SiO_4$ in measurement by an X-ray diffraction analysis.

The phosphor body containing an alkaline earth metal element may contain an appropriate amount of a metal element (for example, Zn, Ga, Al, Y, Gd, Tb) other than alkaline earth metal.

Moreover, the phosphor body containing an alkaline earth metal element may contain an appropriately small amount of a halogen element (for example, F, Cl, Br), sulfur (S), or phosphorus (P).

Examples of the phosphor body include an orange phosphor body having a composition represented by the following formula (1) and an orange phosphor body having a composition represented by the following formula (2).

$$(Sr_{1-x}M_x)_ySiO_5:Eu^{2+} \qquad (1)$$

In the formula, M represents at least one metal selected from the group consisting of Ba, Ca, Mg, and Zn; $0 \leq x < 1.0$; and $2.6 \leq y \leq 3.3$.

$$(Sr_{1-x})_y SiO_5:Eu^{2+}D \qquad (2)$$

In the formula, M represents at least one metal selected from the group consisting of Ba, Ca, Mg, and Zn; D represents a halogen anion selected from the group consisting of F, Cl, and Br; $0 \leq x < 1.0$; and $2.6 \, y \leq 3.3$.

Specific examples of the phosphor body include orange phosphor bodies having compositions such as $Sr_3SiO_5:Eu^{2+}$, $(Sr_{0.9}Mg_{0.025}Ba_{0.075})_3SiO_5:Eu^{2+}$, $(Sr_{0.9}Mg_{0.05}Ba_{0.05})_{2.7}SiO_5:Eu^{2+}$, $(Sr_{0.9}Mg_{0.025}Ba_{0.075})_3SiO_5:Eu^{2+}$, $(Sr_{0.98}Ba_{0.1})_3SiO_5:Eu^{2+}$, $Sr_{0.97}SiO_5:Eu^{2+}F$, $(Sr_{0.9}Mg_{0.0})_{2.9}SiO_5:Eu^{2+}F$, and $(Sr_{0.9}Ca_{0.1})_{3.0}SiO_5:Eu^{2+}F$; green phosphor bodies having compositions such as $(Sr_{0.4}Ba_{0.6})_2SiO_4:Eu^{2+}$, $(Sr_{0.3}Ba_{0.7})_2SiO_4:Eu^{2+}$, $(Sr_{0.2}Ba_{0.8})_2SiO_4: Eu^{2+}$, $(Sr_{0.57}Ba_{0.4}Mg_{0.03})_2SiO_4:Eu^{2+}F$, $(Sr_{0.6}Ba_{0.4})_2SiO_4:Eu^{2+}Cl$, and $(Ba,Sr,Ca)_2(Mg,Zn)Si_2O_7:Eu^{2+}$; yellow phosphor bodies having compositions such as $(Sr_{0.7}Ba_{0.3})_2SiO_4:Eu^{2+}F$, $(Sr_{0.9}Ba_{0.1})_2SiO_4:Eu^{2+}$, $0.72[(Sr_{1.025}Ba_{0.925}Mg_{0.05})Si_{1.03}O_4Eu_{0.05}F_{0.12}]$, and $0.28 [Sr_3Si_{1.02}O_5Eu_{0.6}F_{0.13}]$; and blue phosphor bodies having compositions such as $Ba_2MgSi_2O_7:Eu^{2+}$, and $Ba_2ZnSi_2O_7:Eu^{2+}$.

Among the above examples, the phosphor body is particularly preferably an orange phosphor body having a crystal structure of $M_3SiO_5$.

The particle diameter of the phosphor body is generally preferably a median particle diameter ($D_{50}$) in the range of 0.1 to 100 μm, more preferably in the range of 1.0 to 50 μm, and further preferably in the range of 5.0 to 30 μm, though not limited thereto. If the $D_{50}$ is too small, not only is the brightness decreased, but also the base phosphor body itself tends to agglomerate, making uniform coating difficult. If the $D_{50}$ is too large, the dispersibility of the phosphor body in a resin is deteriorated, which may have a negative influence on the properties of the light-emitting element.

Preferably, after 10-minute immersion of 0.1 parts by weight of the surface-treated phosphor of the present invention in 100 parts by weight of pure water, the water has a conductivity of not higher than 100 mS/m.

If the water has a conductivity of not higher than 100 mS/m, the phosphor is very little decomposed and deteriorated by water, exhibiting excellent moisture resistance.

The conductivity of the water can be measured, for example, with a conductivity meter, or the like.

Preferably, after 10-minute immersion of 0.1 parts by weight of the surface-treated phosphor of the present invention in 100 parts by weight of pure water, the amount of eluted silicon is not more than 50 ppm.

If the amount of the eluted silicon is not more than 50 ppm, the phosphor is less likely to be decomposed and degraded by water, exhibiting excellent moisture resistance.

Preferably, after 10-minute immersion of 0.1 parts by weight of the surface-treated phosphor of the present invention in 100 parts by weight of pure water, the amount of eluted strontium is not more than 200 ppm.

If the amount of the eluted strontium is not more than 200 ppm, the phosphor is less likely to be decomposed and degraded by water, exhibiting excellent moisture resistance.

Meanwhile, the amounts of the eluted silicon and the eluted strontium can be measured by, for example, inductively coupled plasma emission spectroscopy (ICP, Instrument: ICPS-8000, product of Shimadzu Corporation).

The surface-treated phosphor of the present invention can be produced by, for example, a method including the step of dispersing the phosphor body in a solution which includes a complex ion containing the specific element and fluorine to bring the phosphor body into contact with the complex ion so that the surface treatment layer is formed. The method for producing the surface-treated phosphor is also one aspect of the present invention.

Examples of the complex ion containing the specific element and fluorine include a complex ion having a structure of $AF_6^{2-}$ (A: at least one specific element selected from elements of the third to sixth groups of the periodic table).

Furthermore, a complex ion having a structure of $AO_2F_4^{2-}$ or a fluorine-containing solution in which an oxide of the specific element is dissolved can be used.

The surface treatment layer forming the surface-treated phosphor of the present invention can be produced, for example, by performing the step of dispersing the phosphor body in an $AF_6^{2-}$ (A: at least one specific element selected from elements of the third to sixth groups of the periodic table) complex ion-containing solution to bring the phosphor body into contact with the $AF_6^{2-}$ complex ion.

The $AF_6^{2-}$ complex ion generates a free fluorine ion as a result of the following hydrolysis reaction formula (3) in an aqueous solution.

$$AF_6^{2-} + nH_2O \rightarrow [AF_{6-n}(OH)_n]^{2-} + nH^+ + nF^- \qquad (3)$$

The concentration of the $AF_6^{2-}$ complex ion is preferably 0.0005 to 2.0 M, more preferably 0.001 to 1.5 M, and further preferably 0.005 to 1.0 M. If the concentration of the $AF_6^{2-}$ complex ion is too low, the concentration of the free fluorine ion becomes low, leading to a low rate of fluoride-formation reaction. If the rate of fluoride-formation reaction is too low, the phosphor body may be degraded in hydrolysis during the treatment step. If the concentration of the $AF_6^{2-}$

complex ion is too high, the solution itself may be unstable, or the reaction proceeds too fast. As a result, a high quality film may not be produced.

As mentioned earlier, hydrolysis reaction of the $MF_6^{2-}$ complex ion gradually progresses as shown in the formula (3), and then finally $AO_2$ is generated as shown in the following formula (4). The reaction of the formula (4) slowly progresses even without the phosphor body in the solution, and then oxide particles are formed. However, the experiment by the present inventors has revealed that, if the phosphor body is present, an $AO_2$ oxide is preferentially precipitated on the surface of the phosphor body.

The hydrolysis reaction is accelerated by the presence of a compound (hydrolysis accelerator) capable of forming a more stable complex with fluorine ion as shown in the following formula (5). The hydrolysis accelerator used in the present invention can be selected from a compound containing boron (B) or a compound containing aluminum (Al). The compound containing boron or the compound containing aluminum may be used alone or two or more of them may be used in combination.

$$AF_6^{2-} + 2H_2O \rightarrow AO_2 + 4H^+ + 6F^- \qquad (4)$$

$$BO_3^{3-} + 6H^+ + 4F^- \rightarrow BF^{4-} + 3H_2O \qquad (5)$$

Examples of the compound containing boron include boron oxide, sodium tetraborate, and boric acid ($H_3BO_3$), and boric acid is preferable among these.

Examples of the compound containing aluminum include $AlCl_3$, $AlBr_3$, and aluminum hydroxide ($Al(OH)_3$).

The amount of the hydrolysis accelerator relative to the amount of the $AF_6^{2-}$ complex ion is not particularly limited. Normally, the amount of the hydrolysis accelerator is not more than 5-fold or preferably not more than 4-fold of 1 mol of the $AF_6^{2-}$ complex ion.

The reaction time may be appropriately adjusted depending on reaction conditions such as the thickness of the desired oxide layer, the concentration of a reaction liquid, and temperatures. Normally, the reaction time is approximately 5 minutes to 20 hours, and preferably approximately 10 minutes to 10 hours.

In general, in the case where the amount of the charged phosphor body is fixed, the longer the reaction time, the thicker the film becomes. An excessively short reaction time results in a defective surface treatment layer. An excessively long reaction time is uneconomical.

The reaction temperature may be appropriately adjusted depending on the thickness of the desired oxide layer. Normally, the reaction temperature is approximately 0°C to 90°C, preferably 5°C to 70°C, and more preferably 10°C to 50°C.

The dispersion condition for the reaction is not particularly limited as long as the phosphor body can be dispersed. For example, the phosphor body can be dispersed with a magnetic stirrer, mechanically with a motorized stirrer, by gas bubbling, by liquid circulation, by ultrasound wave dispersion, by rotary dispersion with a ball mill or a rotary mixer, or by a combination of these methods.

After the reaction for a predetermined time, the phosphor body is filtered, washed, dried, and then collected. The drying may be performed under normal pressure or reduced pressure. The appropriate temperature for the drying is room temperature to 150°C.

In the method for producing the surface-treated phosphor of the present invention, the dried phosphor body may be further heat-treated at a temperature of 200°C to 600°C.

Under the aforementioned conditions, formation of a fluoride and formation of an oxide of the specific element proceed in practically the same solution. It is estimated that, upon dispersing the phosphor in $AF_6^{2-}$ complex ion-containing solution and bringing the phosphor into contact with the complex ion, the fluoride is preferentially formed. As the formation of the fluoride proceeds, the fluorine ion concentration in the solution is reduced so that the reaction proceeds to right in the above formula (3) or (4). As a result, precipitation of an oxide ($AO_2$) begins to occur.

A product obtained by adding the surface-treated phosphor of the present invention to an epoxy resin and/or a silicone resin can be used as a phosphor-containing resin composition.

The phosphor-containing resin composition is used in known embodiments. For example, the phosphor-containing resin composition may be injected as paste with a dispenser, or may be processed into a tape-like shape or a sheet-like shape and laminated.

The epoxy resin may be a known one, or may be one produced by reacting, for example, a hydroxyl-, carboxyl- or amine-containing compound with epichlorohydrin in the presence of a basic catalyst (e.g. sodium hydroxide) such as metal hydroxide, or the like.

Moreover, the epoxy resin may be one produced by reacting a compound having one or more, or preferably two or more carbon-carbon double bonds with a peroxide (e.g. peracid), or the like.

Examples of the epoxy resin include aliphatic epoxy resin, alicyclic epoxy resin, bisphenol-A epoxy resin, bisphenol-F epoxy resin, phenol novolak epoxy resin, cresol-novolak epoxy resin, biphenyl epoxy resin, 4,4'-biphenyl epoxy resin, multi-functional epoxy resin, divinyibenzene dioxide, and 2-glycidylphenyl glycidyl ether. Among those examples, alicyclic epoxy resin and aliphatic epoxy resin are preferable. These epoxy resins may be used alone, or in combination of two or more kinds thereof.

Examples of the aliphatic epoxy resin-include a compound having one or more aliphatic groups and one or more epoxy groups, specifically, butadiene dioxide, dimethylpentane dioxide, diglycidyl ether, 1,4-butanediol diglycidyl ether, diethylene glycol diglycidyl ether, dipentene dioxide, and the like.

Examples of the alicyclic epoxy resin include a compound having one or more alicyclic groups and one or more oxirane groups, specifically, 2-(3,4-epoxy)cyclohexyl-5,5-spiro-(3,4-epoxy)cyclohexane-m-dioxane, 3,4-epoxycyclohexylalkyl-3,4-epoxycyclohexanecarboxylate, 3,4-epoxy-6-methylcyclohexylmethyl-3,4-epoxy-6-methylcyclohexanecarboxylate, vinylcyclohexane dioxide, bis(3,4-epoxycyclohexylmethyl)adipate, bis(3,4-epoxy-6-methylcyclohexylmethyl)adipate, exo-exo bis(2,3-epoxy cyclopentyl)ether, endo-exo bis(2,3-epoxycyclopentyl)ether, 2,2-bis(4-(2,3-epoxypropoxy)cyclohexyl)propane, 2,6-bis(2,3-epoxypropoxycyclohexyl-p-dioxane), 2,6-bis(2,3-epoxypropoxy)norbornene, diglycidyl ether of linoleic acid dimer, limonene dioxide, 2,2-bis(3,4-epoxycyclohexyl)propane, dicyclopentadiene dioxide, 1,2-epoxy-6-(2,3-epoxypropoxy)hexahydro-4,7-methanoindan, p-(2,3-epoxy)cyclopentylphenyl-2,3-epoxypropyl ether, 1-(2,3-epoxypropoxy)phenyl-5,6-epoxyhexahydro-4,7-methanoindan, o-(2,3-epoxy)cyclopentylphenyl-2,3-epoxypropyl ether), 1,2-bis[5-(1,2-epoxy)-4,7-hexahydromethanoindanoxyl]ethane, cyclopentyl phenylglycidyl ether, cyclohexanediol diglycidyl ether, diglycidyl hexahydrophthalate, and the like.

Commonly known silicone resins may be used as the silicone resin, and examples thereof include one having a (-SiR$^1$R$^2$-O-)n polysiloxane backbone. The R$^1$R$^2$ is preferably one having 2 to 10 carbons, more preferably one having 2 to 6 carbons, and examples thereof include alkenyl groups such as a vinyl group, an allyl group, a propenyl group, an isopropenyl group, and a butenyl group; an acryloxy group; and a methacryloxy group. The R$^2$ is preferably one having 1 to 10 carbons, more preferably one having 1 to 6 carbons, and typical examples thereof include alkyl groups such as a methyl group, an ethyl group, a propyl group, a butyl group, and a cyclohexyl group; aryl groups such as a phenyl group and a tryl group; and aralkyl groups such as a benzyl group.

The surface-treated phosphor of the present invention can be used as a wavelength conversion complex after it is dispersed in at least one resin selected from the group consisting of polyvinyl acetate, polyvinyl butyral, polyethylene, polypropylene, polymethyl methacrylate, polycarbonate, and cyclic olefin copolymers.

The wavelength conversion complex can be used as a wavelength conversion member for lighting systems, solar cells, or the like.

The method for producing the wavelength conversion complex is not particularly limited. The surface-treated phosphor of the present invention may be subjected to a known surface treatment that is appropriate for the corresponding resin. Moreover, the surface-treated phosphor body may be dispersed in the resin by a conventional kneading and dispersing method.

The wavelength conversion complex can be used as a wavelength conversion sheet after it is formed into a sheet shape. The sheet-shaping may be performed by a known method. Specifically exemplified are, for example, a method in which a masterbatch containing the surface-treated phosphor of the present invention and a resin is prepared, and then the masterbatch is formed into a film with an extruder; a method in which a resin and the surface-treated phosphor of the present invention are dispersed in a solvent capable of dissolving the resin, and then the resulting mixture is cast; and the like.

Use of the wavelength conversion complex of the present invention or the wavelength conversion sheet of the present invention enables production of an efficient photovoltaic device. Such a photovoltaic device is also one aspect of the present invention.

In a photovoltaic device, typically a solar cell, the wavelength of received light is not always an efficient wavelength for the element itself. In the case of inefficient wavelength, the wavelength of the received light is converted to a wavelength that is efficient for the element so that the photovoltaic device has a better conversion efficiency.

Meanwhile, a conventional phosphor has low moisture resistance, and thus cannot be favorably used. By dispersing the surface-treated phosphor of the present invention in a sealing resin and applying the resulting mixture to the surface of a solar cell, an efficient solar cell can be produced.

A semiconductor light-emitting element can be produced by forming a phosphor layer including the surface-treated phosphor of the present invention. Such a semiconductor light-emitting element is also one aspect of the present invention.

Further, an LED light-emitting device including an LED chip, a resin frame surrounding the LED chip, and a phosphor layer filled in a concave portion formed by the resin frame can have excellent moisture resistance if the phosphor layer includes the surface-treated phosphor of the present invention and a sealing resin. Such an LED light-emitting device is also one aspect of the present invention.

The LED light-emitting device of the present invention has a luminosity retention ratio of not less than 80% after energization for 1000 hours under conditions of a temperature of 60°C, a relative humidity of 90%, and a current of 20 mA. A luminosity retention ratio of less than 80% tends to reduce the luminosity with time in a practical use, which may result in insufficient durability. The luminosity retention ratio is preferably not less than 90%.

Meanwhile, the luminosity retention ratio used herein refers to a ratio [(luminosity after energization/luminosity before energization)×100] between the luminosities before and after the energization under the aforementioned conditions. The luminosity can be measured with, for example, an OL 770 measurement system produced by Optronic Laboratories.

The LED light-emitting device of the present invention preferably has a luminosity retention ratio of not less than 50% after energization for 72 hours under conditions of a temperature of 121°C and a relative humidity of 100%.

Use application of the LED light-emitting device of the present invention is not particularly limited. The LED light-emitting device can be used in various fields where an ordinary LED light-emitting device is used. It may be used alone, or a plurality of them can be used in combination. Specifically, the LED light-emitting device of the present invention can be used in, for example, a backlight for a liquid crystal display element, an image display device, or a lighting apparatus.

The backlight for a liquid crystal display element may be configured as conventionally known manners. For example, the backlight may be disposed at a frame portion of a display element and may emit light towards a light guide panel, or the backlight may be disposed at a back side of a diffuser panel which is interposed behind a liquid crystal cell.

One example of the image display device is a liquid crystal display element including at least a liquid crystal cell and the backlight for a liquid crystal display element. As another example, an LED display may be exemplified which produces images by two-dimensionally aligning a plurality of LEDs regularly, and selectively lighting the LEDs.

Moreover, the lighting apparatus is not particularly limited, and can be applied for a known LED light-emitting device. Since the lighting apparatus has high moisture resistance, it can be applied for, for example, signal light and illumination light used in traffic or transport of vehicles or the like; exterior and interior lighting used in houses, buildings, or the like; lighting used in mobile phones, mobile communication terminals, or the like.

EFFECT OF THE INVENTION

The present invention provides a surface-treated phosphor having excellent moisture resistance, which can prevent the surface from being decomposed and degraded by damp in the air or water, and can avoid reduction in the luminosity or changes of color tone even in use in high temperature and high humidity environment for a long time. Moreover, according to the method for producing the surface-treated phosphor of the present invention, coating treatment can be performed in an aqueous solution in a short time without using an expensive reaction apparatus. Therefore, the desired surface-treated phosphor can be efficiently and economically produced.

BRIEF DESCRIPTION OF THE DRAWINGS

Fig. 1 is a cross-sectional picture of a cross section of a surface-treated phosphor obtained in Example 1.
Fig. 2 is element distribution data in cross-sectional direction of the surface-treated phosphor obtained in Example 1.
Fig. 3 is a cross-sectional picture of a cross section of a surface-treated phosphor obtained in Example 2.
Fig. 4 is element distribution data in cross-sectional direction of the surface-treated phosphor obtained in Example 2.
Fig. 5 is a cross-sectional picture of a cross section of a surface-treated phosphor obtained in Example 3.
Fig. 6 is element distribution data in cross-sectional direction of the surface-treated phosphor obtained in Example 3.
Fig. 7 is a cross-sectional picture of a cross section of a surface-treated phosphor obtained in Example 4.
Fig. 8 is element distribution data in cross-sectional direction of the surface-treated phosphor obtained in Example 4.
Fig. 9 is a cross-sectional picture of a cross section of a surface-treated phosphor obtained in Example 5.
Fig. 10 is element distribution data in cross-sectional direction of the surface-treated phosphor obtained in Example 5.
Fig. 11 is a cross-sectional picture of a cross section of a surface-treated phosphor obtained in Example 6.
Fig. 12 is a cross-sectional picture of a cross section of a surface-treated phosphor obtained in Example 7.
Fig. 13 is element distribution data in cross-sectional direction of the surface-treated phosphor obtained in Example 7.
Fig. 14 is a cross-sectional picture of a cross section of a surface-treated phosphor obtained in Comparative Example 1.
Fig. 15 is element distribution data in cross-sectional direction of the surface-treated phosphor obtained in Comparative Example 1.
Fig. 16 is a cross-sectional picture of a cross section of a surface-treated phosphor obtained in Comparative Example 2.
Fig. 17 is element distribution data in cross-sectional direction of the surface-treated phosphor obtained in Comparative Example 2.
Fig. 18 is a cross-sectional picture of a cross section of a surface-treated phosphor obtained in Comparative Example 3.

Fig. 19 is element distribution data in cross-sectional direction of the surface-treated phosphor obtained in Comparative Example 3.

Fig. 20 is a cross-sectional picture of a cross section of a surface-treated phosphor obtained in Comparative Example 4.

Fig. 21 is element distribution data in cross-sectional direction of the surface-treated phosphor obtained in Comparative Example 4.

MODES FOR CARRYING OUT THE INVENTION

The present invention will be further described hereinafter referring to examples; however, the present invention is not limited thereto.

Example 1

An amount of 7.5 g of an orange silicate phosphor body ($Sr_3SiO_5:Eu^{2+}$) having a median particle diameter ($D_{50}$) of about 17 $\mu$m was added to 250 ml of a mixed solution containing ammonium fluorotitanate ($(NH_4)_2TiF_6$) (0.1 mol/L) and boric acid (0.1 mol/L). The phosphor body-containing mixed solution was stirred so as to disperse the phosphor body, and thereby was allowed to react at 35°C for two hours, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the methods mentioned below. The results showed that a surface treatment layer having a thickness of about 180 nm was formed on the surface of the phosphor body.

As elemental composition curves obtained by the analysis of the elemental composition in a cross-sectional direction, a curve showing the titanium content and a curve showing the fluorine content were obtained. It was confirmed that a peak indicating the maximum content of titanium appeared nearer to the surface than a peak indicating the maximum fluorine content. The amounts of the specific elements other than titanium were not more than the detection limits.

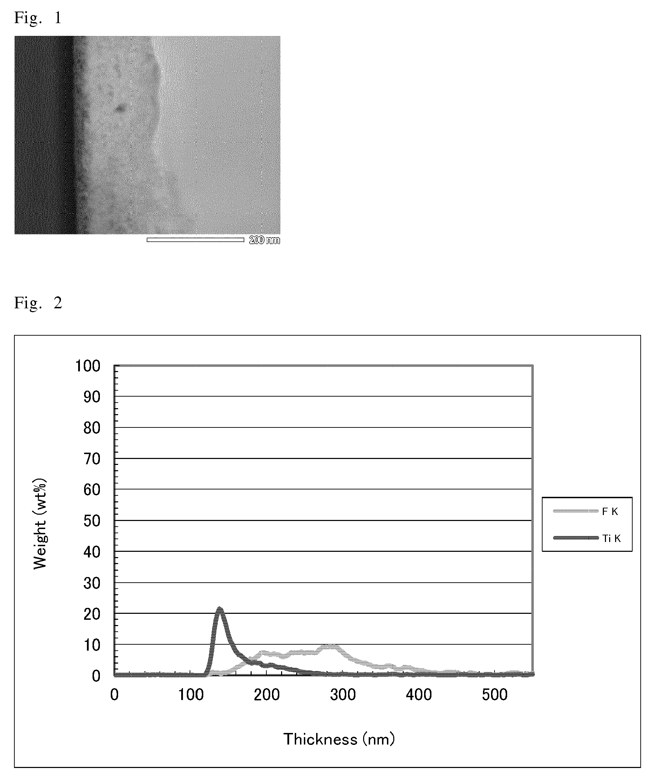

The fluorine content at the peak indicating the maximum titanium content was 1.0% by weight. Fig. 1 shows an FE-TEM cross-sectional picture of the obtained surface-treated phosphor. Fig. 2 shows the results of the elemental analysis in the cross-sectional direction.

<Measurement of thickness of coating layer, elemental composition analysis in a cross-sectional direction>

The obtained surface-treated phosphor was cut in a cross-sectional direction using focused ion beam (FIB). The cut surface was observed with a field emission-transmission electron microscope (FE-TEM, JEM-2010FEF) so that the thickness of the surface treatment layer was measured. The thickness was a mean value of thicknesses measured at five locations.

The elemental composition of the surface treatment layer was analyzed by energy dispersive X-ray spectroscopy (EDX) accompanied with the FE-TEM and was identified. Thereby, curves of the contents of the specific element (element of the third to sixth groups of the periodic table) and fluorine in a thickness direction were obtained.

Example 2

An amount of 7.5 g of an orange silicate phosphor body (principal component: $Sr_3SiO_5:Eu^{2+}$) having a median particle diameter ($D_{50}$) of about 17 $\mu$m was added to 250 ml of a mixed solution containing ammonium fluorotitanate ($(NH_4)_2TiF_6$) (0.1 mol/L) and boric acid (0.1 mol/L). The phosphor body-containing mixed solution was stirred so as to disperse the phosphor body, and thereby was allowed to react at 35°C for four hours, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the same methods as those in Example 1. The results showed that a surface treatment layer having a thickness of about 210 nm was formed on the surface of the phosphor body.

As elemental composition curves obtained by the analysis of the elemental composition in a cross-sectional direction, a curve showing titanium content and a curve showing fluorine content were obtained. It was confirmed that a peak indicating the maximum content of titanium appeared nearer to the surface than a peak indicating the maximum fluorine content. The amounts of the specific elements other than titanium were not more than the detection limits.

The fluorine content at the peak indicating the maximum titanium content was 1.8% by weight.

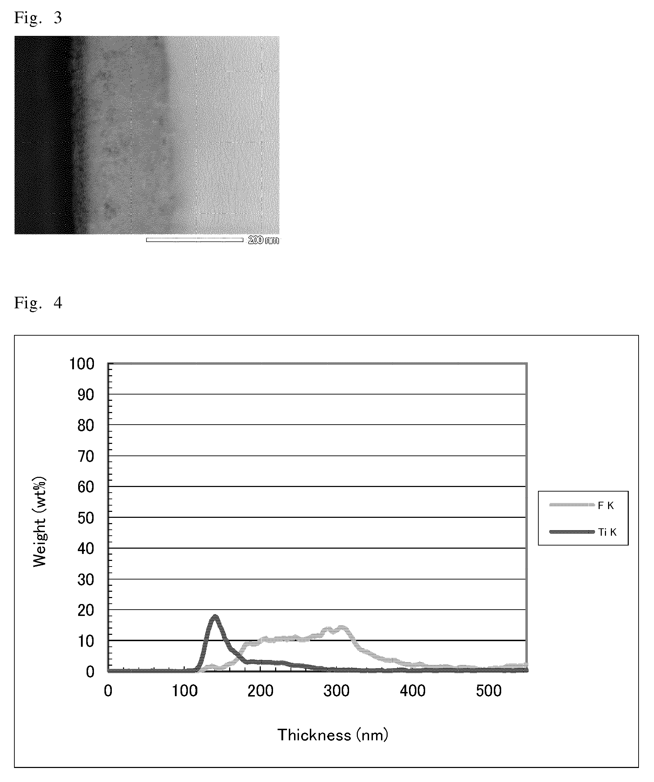

Fig. 3 shows an FE-TEM cross-sectional picture of the obtained surface-treated phosphor. Fig. 4 shows the results of the elemental analysis in the cross-sectional direction.

Example 3

An amount of 7.5 g of an orange silicate phosphor body (principal component: $Sr_3SiO_5:Eu^{2+}$) having a median particle diameter ($D_{50}$) of about 17 $\mu$m was added to 250 ml of a solution containing ammonium fluorotitanate (($NH_4)_2TiF_6$) (0.75 mol/L). The phosphor body-containing mixed solution was stirred so as to disperse the phosphor body, and thereby was allowed to react at 35°C for 30 minutes, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the same methods as those in Example 1. The results showed that a coating layer having a thickness of about 250 nm was formed on the surface of the phosphor body.

As elemental composition curves obtained by the analysis of the elemental composition in a cross-sectional direction, a curve showing titanium content and a curve showing fluorine content were obtained. It was confirmed that a peak indicating the maximum content of titanium appeared nearer to the surface than a peak indicating the maximum fluorine content. The amounts of the specific elements other than titanium were not more than the detection limits.

The fluorine content at the peak indicating the maximum titanium content was 4.8% by weight.

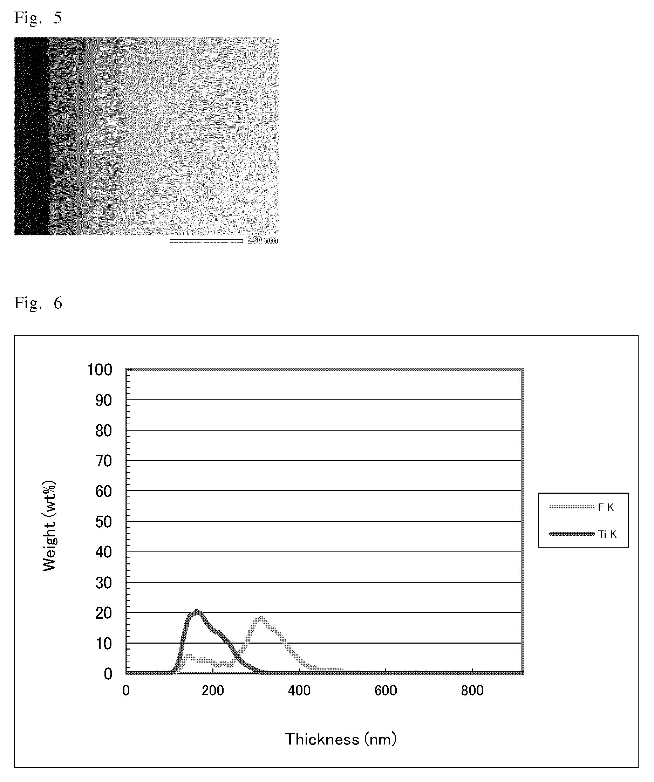

Fig. 5 shows an FE-TEM cross-sectional picture of the obtained surface-treated phosphor. Fig. 6 shows the results of the elemental analysis in the cross-sectional direction.

Example 4

An amount of 7.5 g of an orange silicate phosphor body (principal component: $Sr_3SiO_5:Eu^{2+}Cl$) having a median particle diameter ($D_{50}$) of about 17 $\mu$m was added to 250 ml of a solution containing ammonium fluorotitanate (($NH_4)_2TiF_6$) (1.0 mol/L). The phosphor body-containing mixed solution was stirred so as to disperse the phosphor body, and thereby was allowed to react at 35°C for 30 minutes, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the same methods as those in Example 1. The results showed that a coating layer having a thickness of about 300 nm was formed on the surface of the phosphor body.

As elemental composition curves obtained by the analysis of the elemental composition in a cross-sectional direction, a curve showing titanium content and a curve showing fluorine content were obtained. It was confirmed that a peak indicating the maximum content of titanium appeared nearer to the surface than a peak indicating the maximum fluorine content. The amounts of the specific elements other than titanium were not more than the detection limits.

The fluorine content at the peak indicating the maximum titanium content was 6.0% by weight.

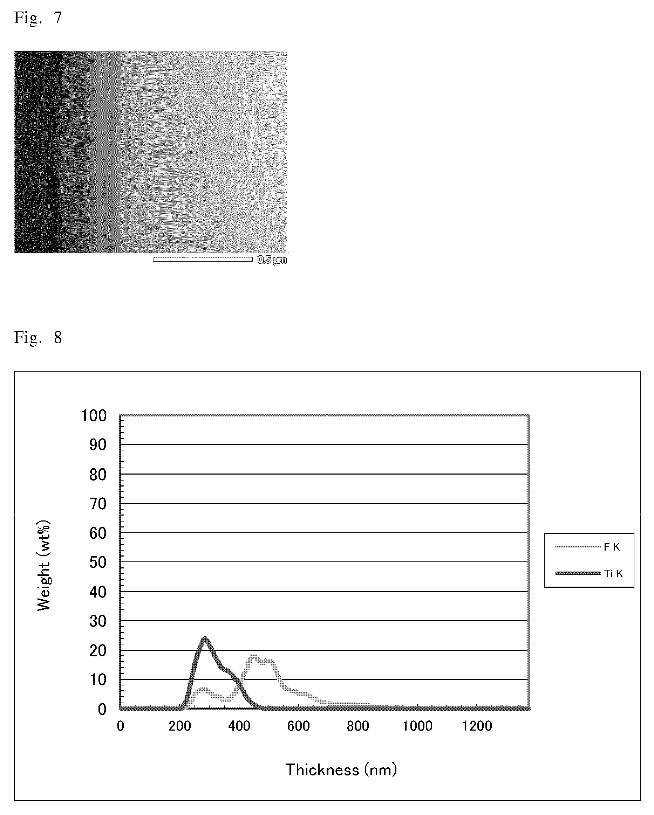

Fig. 7 shows an FE-TEM cross-sectional picture of the obtained surface-treated phosphor. Fig. 8 shows the results of the elemental analysis in the cross-sectional direction.

Example 5

An amount of 7.5 g of an orange silicate phosphor body (principal component: $Sr_3SiO_5:Eu^{2+}$) having a median particle diameter ($D_{50}$) of about 17 $\mu$m was added to 250 ml of a mixed solution containing ammonium fluorotitanate (($NH_4)_2TiF_6$) (0.02 mol/L) and boric acid (0.02 mol/L). The phosphor body-containing mixed solution was stirred so as to disperse the phosphor body, and thereby was allowed to react at 35°C for two hours, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the same methods as those in Example 1. The results showed that a coating layer having a thickness of about 110 nm was formed on the surface of the phosphor body.

As elemental composition curves obtained by the analysis of the elemental composition in a cross-sectional direction, a curve showing titanium content and a curve showing fluorine content were obtained. It was confirmed that a peak indicating the maximum content of titanium appeared nearer to the surface than a peak indicating the maximum fluorine content. The amounts of the specific elements other than titanium were not more than the detection limits.

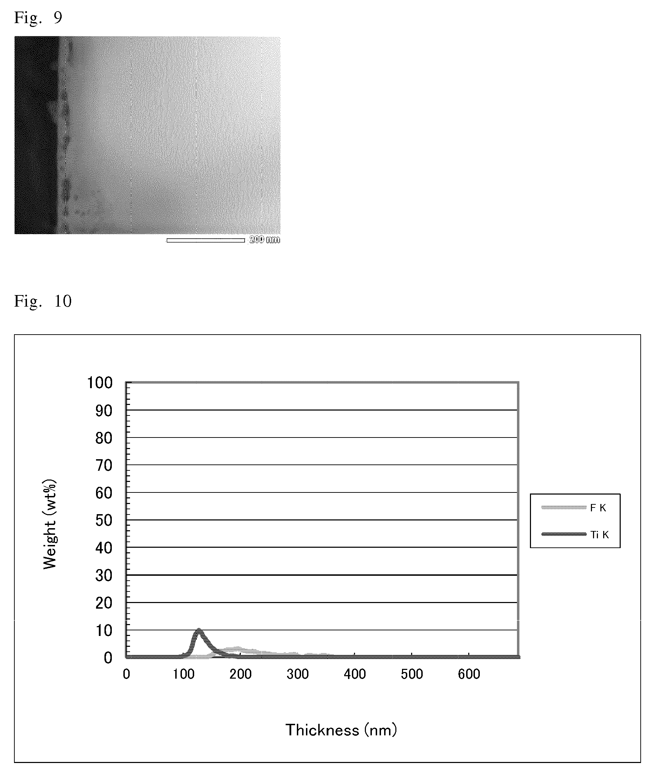

The fluorine content at the peak indicating the maximum titanium content was 0.15% by weight. Fig. 9 shows an FE-TEM cross-sectional picture of the obtained surface-treated phosphor. Fig. 10 shows the results of the elemental analysis in the cross-sectional direction.

Example 6

An amount of 1.5 g of an orange silicate phosphor body (principal component: $Sr_3SiO_5:Eu^{2+}$) having a median particle diameter ($D_{50}$) of about 17 $\mu$m was added to 250 ml of a mixed solution containing ammonium fluorotitanate

$((NH_4)_2TiF_6)$ (0.1 mol/L) and boric acid (0.2 mol/L). The phosphor body-containing mixed solution was stirred so as to disperse the phosphor body, and thereby was allowed to react at 35°C for two hours, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the same methods as those in Example 1. The results showed that a coating layer having a thickness of about 200 nm was formed on the surface of the phosphor body.

As elemental composition curves obtained by the analysis of the elemental composition in a cross-sectional direction, a curve showing titanium content and a curve showing fluorine content were obtained. It was confirmed that a peak indicating the maximum content of titanium appeared nearer to the surface than a peak indicating the maximum fluorine content. The amounts of the specific elements other than titanium were not more than the detection limits.

The fluorine content at the peak indicating the maximum titanium content was 2.5% by weight.

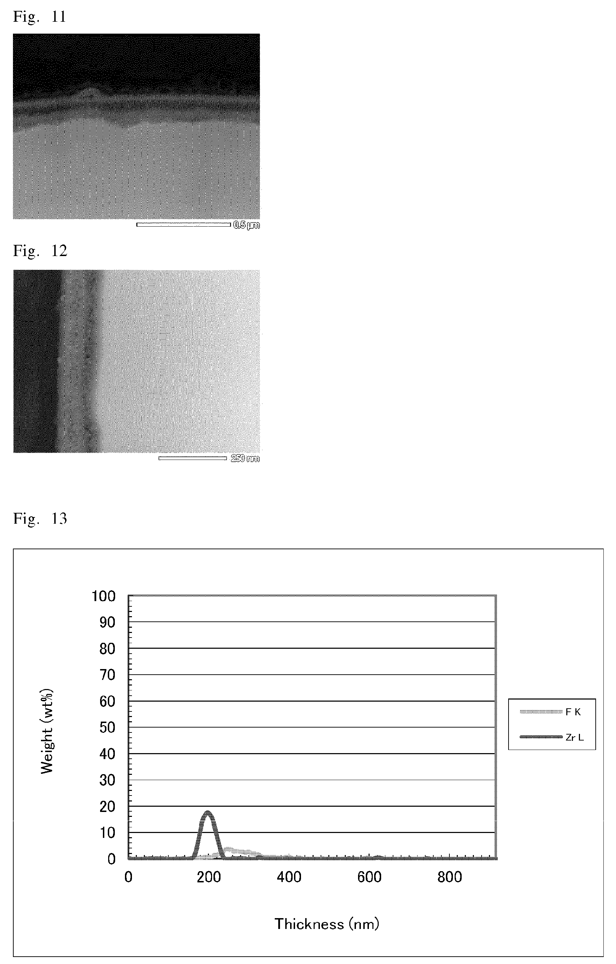

Fig. 11 shows an FE-TEM cross-sectional picture of the obtained surface-treated phosphor.

Example 7

An amount of 7.5 g of an orange silicate phosphor body (principal component: $Sr_3SiO_5:Eu^{2+}$) having a median particle diameter ($D_{50}$) of about 17 $\mu$m was added to 250 ml of a mixed solution containing ammonium fluorozirconate $((NH_4)_2ZrF_6)$ (0.1 mol/L) and boric acid (0.1 mol/L). The phosphor body-containing mixed solution was stirred so as to disperse the phosphor body, and thereby was allowed to react at 35°C for two hours, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the same methods as those in Example 1. The results showed that a coating layer having a thickness of about 170 nm was formed on the surface of the phosphor body.

As elemental composition curves obtained by the analysis of the elemental composition in a cross-sectional direction, a curve showing zirconium content and a curve showing fluorine content were obtained. It was confirmed that a peak indicating the maximum content of zirconium appeared nearer to the surface than a peak indicating the maximum fluorine content. The amounts of the specific elements other than zirconium were not more than the detection limits.

The fluorine content at the peak indicating the maximum zirconium content was 0.6% by weight.

Fig. 12 shows an FE-TEM cross-sectional picture of the obtained surface-treated phosphor. Fig. 13 shows the results of the elemental analysis in the cross-sectional direction.

Example 8

An amount of 7.5 g of an orange silicate phosphor body (principal component: $Sr_3SiO_5:Eu^{2+}$) having a median particle diameter ($D_{50}$) of about 17 $\mu$m was added to 250 ml of a hydrofluoric acid solution containing vanadium oxide (0.05 mol/L) dissolved therein. The phosphor body-containing mixed solution was stirred so as to disperse the phosphor body, and thereby was allowed to react at 35°C for 30 hours, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the same methods as those in Example 1. The results showed that a coating layer having a thickness of about 100 nm was formed on the surface of the phosphor body.

As elemental composition curves obtained by the analysis of the elemental composition in a cross-sectional direction, a curve showing vanadium content and a curve showing fluorine content were obtained. It was confirmed that a peak indicating the maximum content of vanadium appeared nearer to the surface than a peak indicating the maximum fluorine content. The amounts of the specific elements other than vanadium were not more than the detection limits.

The fluorine content at the peak indicating the maximum vanadium content was 3.6% by weight.

Example 9

An amount of 7.5 g of an orange silicate phosphor body (principal component: $Sr_3SiO_5:Eu^{2+}$) having a median particle diameter ($D_{50}$) of about 17 $\mu$m was added to 250 ml of a solution containing ammonium molybdate $((NH_4)_2MoO_2F_4)$ (0.1 mol/L). The phosphor body-containing mixed solution was stirred so as to disperse the phosphor body, and thereby was allowed to react at 35°C for 30 hours, followed by filtration and washing. The collected phosphor body was dried in vacuum at 120°C for one hour.

The resulting surface-treated phosphor was tested for "measurement of the thickness of the coating layer, and elemental composition analysis in a cross-sectional direction" by the method mentioned below. The results showed that a coating layer having a thickness of about 50 nm was formed on the surface of the phosphor body.

As elemental composition curves obtained by the analysis of the elemental composition in a cross-sectional direction, a curve showing molybdenum content and a curve showing fluorine content were obtained. It was confirmed that a peak indicating the maximum content of molybdenum appeared nearer to the surface than a peak indicating the maximum fluorine content. The amounts of the specific elements other than molybdenum were not more than the detection limits.

The fluorine content at the peak indicating the maximum molybdenum content was 1.5% by weight.

Comparative Example 1

An orange silicate phosphor body (principal component: $Sr_3SiO_5:Eu^{2+}$) having a median particle diameter ($D_{50}$) of about 17 $\mu$m without surface treatment was tested for "measurement of the thickness of the coating layer, and elemental composition analysis in a cross-sectional direction" by the same methods as those in Example 1. No surface treatment layer was formed on the surface of the phosphor body. Thus, no curve showing a content of a specific element and no curve showing fluorine content were obtained.

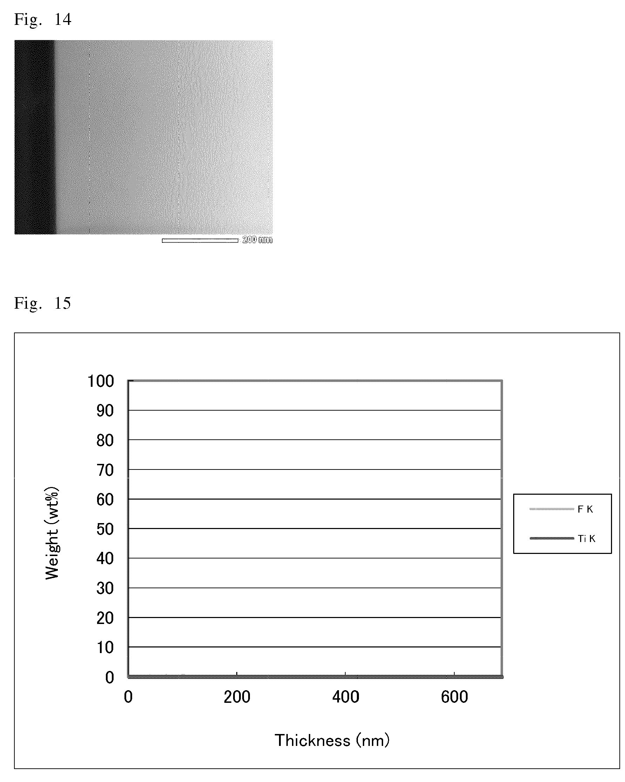

Fig. 14 and Fig. 15 show an FE-TEM cross-sectional picture of the obtained phosphor and the results of the elemental analysis in the cross-sectional direction, respectively.

Comparative Example 2

An amount of 1.0 g of silicate phosphor body particles (principal component: $Sr_3SiO_5:Eu^{2+}$) were added to an aqueous mixed solution of ethanol containing 2.0% trifluoropropyl trimethoxysilane dissolved therein and 0.01% acetic acid water (ethanol:water = 5:1) and the mixture was reacted for one hour. Thereafter, the ethanol was removed, followed by drying in vacuum at 110°C for one hour, so that the phosphor particles were collected.

The thus treated phosphor particles were tested for "measurement of the thickness of the coating layer, and elemental composition analysis in a cross-sectional direction" by the same methods as those in Example 1. The results showed that a coating layer having a thickness of about 47 nm was formed on the surface.

As an elemental composition curve obtained by the analysis of the elemental composition in a cross-sectional direction, only a curve showing fluorine content was obtained. The amount of the specific element was not more than the detection limit.

Moreover, the fluorine content at the peak indicating the maximum fluorine content in the surface treatment layer was 9.5% by weight.

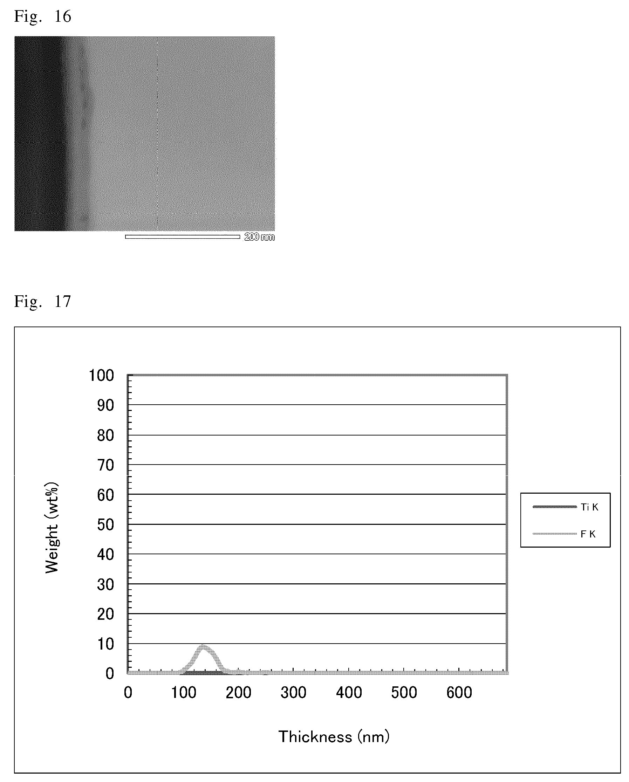

Fig. 16 shows an FE-TEM cross-sectional picture of the obtained surface-treated phosphor. Fig. 17 shows the results of the elemental analysis in the cross-sectional direction.

Comparative Example 3

An amount of 8.4 g of titanium isopropoxide (product of Kanto Chemical Co. Inc.) was added and dissolved in a mixture of absolute ethanol (400 mL) and 12.0 g of orange silicate phosphor body particles (principal component: $Sr_3SiO_5:Eu^{2+}$) dispersed therein. Next, 120 mL of ethanol solution containing 4.2 g of water (the pH was adjusted to 9.0 with ammonium water) was dropwise added to the dispersion solution at a rate of 0.5 mL/min. After the addition, the resulting mixture was further stirred for one hour, followed by filtration and washing, and then the phosphor particles were collected. The collected phosphor particles were dried in vacuum at 120°C for one hour.

The coated phosphor particles were tested for "measurement of the thickness of the coating layer, and elemental composition analysis in a cross-sectional direction" by the same methods as those in Example 1. The results showed that a coating layer having a thickness of about 34 nm was formed on the surface.

As an elemental composition curve obtained by the analysis of the elemental composition in a cross-sectional direction, only a curve showing titanium content was obtained. The fluorine content was not more than the detection limit.

Moreover, the titanium content at the peak indicating the maximum titanium content in the surface treatment layer was 20% by weight.

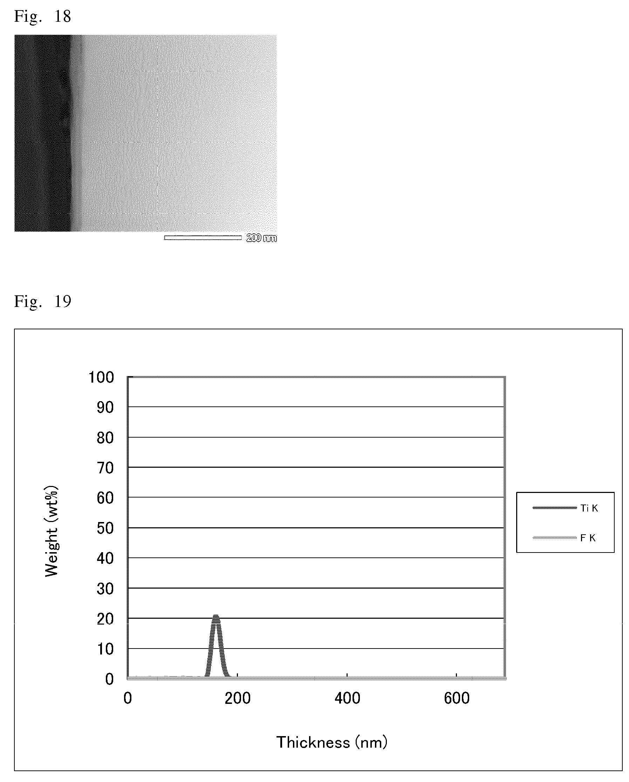

Fig. 18 shows an FE-TEM cross-sectional picture of the obtained surface-treated phosphor. Fig. 19 shows the results of the elemental analysis in the cross-sectional direction.

Comparative Example 4

An amount of 8.4 g of titanium isopropoxide (product of Kanto Chemical Co. Inc.) was added and dissolved in a mixture of absolute ethanol (400 mL) and 12.0 g of orange silicate phosphor body particles (principal component: $Sr_3SiO_5:Eu^{2+}$) dispersed therein. Next, 120 mL of ethanol solution containing 4.2 g of water (the pH was adjusted to 9.0 with ammonium water) was dropwise added to the dispersion solution at a rate of 0.5 mL/min. After the addition, the resulting mixture was further stirred for one hour, followed by filtration and washing, and then the phosphor body particles were collected. The collected phosphor body particles were dried in vacuum at 120°C for one hour.

The dried phosphor particles were added to a mixed solution of ethanol containing 2.0% trifluoropronyl trimethoxysilane dissolved therein and 0.01% acetic acid water (ethanol:water = 5:1), and the mixture was reacted for one hour. Thereafter, the ethanol was removed, followed by drying in vacuum at 110°C for one hour, so that the phosphor particles were collected.

The coated phosphor particles were tested for "measurement of the thickness of the coating layer, and elemental composition analysis in a cross-sectional direction" by the same methods as those in Example 1. The results showed that a coating layer having a thickness of about 55 nm was formed on the surface.

As elemental composition curves obtained by the analysis of the elemental composition in a cross-sectional direction, a curve showing titanium content and a curve showing fluorine content were obtained. It was confirmed that a peak indicating the maximum content of titanium appeared nearer to the phosphor body than a peak indicating the maximum fluorine content. The amounts of the specific elements other than titanium were not more than the detection limits.

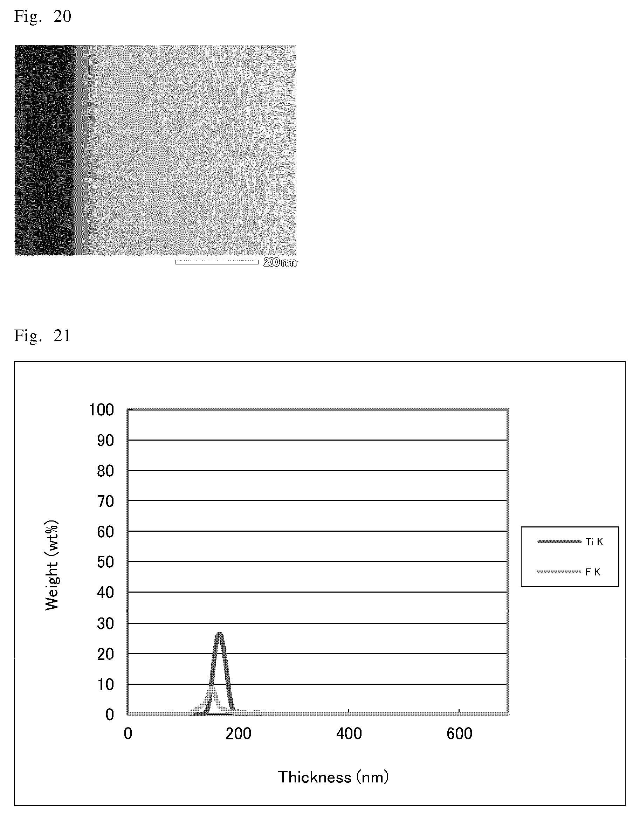

Fig. 20 shows an FE-TEM cross-sectional picture of the obtained surface-treated phosphor. Fig. 21 shows the results of the elemental analysis in the cross-sectional direction.

(Evaluation method)

<Evaluation 1 on moisture resistance of phosphor (PCT Test)>

The surface-treated phosphors or phosphor bodies obtained in the respective Examples and Comparative Examples each were mixed and dispersed in an amount of 8 parts by weight for 100 parts by weight of a silicone resin (product of Dow Corning Corporation, OE6630). The resulting mixture was further deaerated so that a phosphor-containing resin composition was prepared. Next, the prepared phosphor-containing resin composition was injected and filled in an LED package (light emission peak wavelength: 460 nm) mounted on a substrate, and then heated at 150° for two hours to cure the resin composition. Through the aforementioned process, an LED light-emitting device was produced.

Moisture resistant test (Pressure cooker test (PCT)) was performed on the produced LED light-emitting device in a sealed pressure-resistant apparatus in which the temperature was set at 121°C and the relative humidity was 100%.

The luminescence properties of the LED chip was measured before and after the PCT test. The moisture resistance of the phosphor was evaluated based on the changes in the luminosity. Specifically, a ratio of the luminosity after the 72-hour PCT test to the luminosity before the PCT test was obtained as a luminosity retention ratio (PCT72h luminosity retention ratio) for each sample. Based on the PCT72h luminosity retention ratios, relative moisture resistances among samples were assessed.

```
PCT72h luminosity retention ratio (%) =
(luminosity after PCT72h treatment/luminosity before
treatment) × 100
```

An OL 770 measurement system produced by Optronic Laboratories was used for the measurement. Table 1 shows the result.

<Evaluation 2 on moisture resistance of phosphor (Power-on Test)>

First, an LED light-emitting device was prepared in the same manner as in "Evaluation 1 on Moisture Resistance of Phosphor (PCT Test)."

Next, the prepared LED light-emitting device was energized at a constant current of 20 mA for 1000 hours in a thermo-hygrostat in which the temperature was set to 60°C and the relative humidity was 90%. The luminescence properties of the LED chip was measured before and after the energization. The moisture resistance was evaluated based on the changes in the luminosity. Specifically, a ratio of the luminosity after 1000-hour energization to the luminosity before the energization (initial luminosity) was obtained as a luminosity retention ratio for each sample. Based on the luminosity retention ratios, relative moisture resistance among samples was assessed.

$$\text{Luminosity retention ratio after 1000-hour energization (\%)} = (\text{luminosity after 1000-hour energization/luminosity before energization}) \times 100$$

An OL 770 measurement system produced by Optronic Laboratories was used for the measurement. Table 1 shows the result.

<Evaluation 3 on moisture resistance of phosphor (Measurement of conductivity after water immersion)>

The surface-treated phosphors or phosphor bodies (1 g) obtained in the respective Examples and Comparative Examples each were added to 1000 g of pure water (temperature: 35 °C) while stirring. The conductivity of the dispersion 10 minutes after the addition was measured with a conductivity meter (ES-51, product of HORIBA Ltd.).

<Evaluation 4 on moisture resistance of phosphor (Measurement of eluted Si and Sr concentrations during water immersion)>

The surface-treated phosphors or phosphor bodies (1 g) obtained in the respective Examples and Comparative Examples each were added to 1000 g of pure water (temperature: 35 °C) while stirring. The dispersion 10 minutes after the addition was filtrated. Concentrations of Si and Sr in the filtrate were measured by inductively coupled plasma emission spectroscopy (ICP, Instrument: ICPS-8000, product of Shimadzu Corporation).

<Evaluation on dispersibility of phosphor>

The dispersibility of the phosphor in a resin was evaluated with a centrifugal sedimentation and light transmissive type dispersion stability analyzer (LUMiSizer 612, product of L.U.M GmbH). Specifically, the surface-treated phosphors or phosphor bodies obtained in the respective Examples and Comparative Examples each in an amount of 8% by weight were dispersed in a silicone resin to prepare a phosphor-silicone resin composition. About 1 mL of the phosphor-silicone resin composition was placed in a glass analysis cell, and a supernatant thereof was irradiated with light. The integration value of the change in the amount of the light transmitting per hour was obtained, and the dispersibility was evaluated.
The change in the amount of light transmitted through the phosphor-resin composition including the phosphor of Comparative 1 was set 1.00. Table 1 shows the ratios relative to the phosphor-resin composition including the phosphor of Comparative Example 1.

Table 1

| | Phosphor body | Specific element | | Fluorine | | Evaluation | | | | | |
|---|---|---|---|---|---|---|---|---|---|---|---|
| | | Kind | Amount at a peak indicating the maximum content (wt%) | Amount at a peak indicating the maximum content (wt%) | Amount at a peak indi-cating the maximum specific ele-ment con-tent (wt%) | PCT72h lu-minosity re-tention ratio (%) | Luminosity re-tention ratio af-ter 1000h en-ergization (%) | Conductivity after water im-mersion (mS/m) | Concentration of eluted Si after water immersion (ppm) | Concentration of eluted Sr after water immersion (ppm) | Dispersibility |
| Example 1 | $Sr_3SiO_5: Eu^{2+}$ | Ti | 21 | 10 | 1.0 | 73.5 | 95.8 | 50.1 | 22.6 | 123.4 | 0.86 |
| Example 2 | $Sr_3SiO_5: Eu^{2+}$ | Ti | 18 | 14 | 1.8 | 71.2 | 97.6 | 50.9 | 24.5 | 120.0 | 0.85 |
| Example 3 | $Sr_3SiO_5:Eu^{2+}$ | Ti | 20 | 18 | 4.8 | 88.5 | 99.1 | 38.7 | 13.0 | 95.6 | 0.86 |
| Example 4 | $Sr_3SiO_5: Eu^{2+}Cl$ | Ti | 24 | 17.5 | 6.0 | 93.1 | 99.9 | 35.6 | 10.8 | 90.8 | 0.86 |
| Example 5 | $Sr_3SiO_5: Eu^{2+}$ | Ti | 10 | 3 | 0.15 | 61.4 | 93.5 | 56.5 | 30.2 | 134.4 | 0.86 |
| Example 6 | $Sr_aSiO_5: Eu^{2+}$ | Ti | 55 | 26 | 2.5 | 81.0 | 98.6 | 41.7 | 13.9 | 105.6 | 0.86 |
| Example 7 | $Sr_3SiO_5: Eu^{2+}$ | Zr | 17.5 | 4 | 0.6 | 82.3 | 92.3 | 40.5 | 13.1 | 105.0 | 0.84 |
| Example 8 | $Sr_3SiO_5: Eu^{2+}$ | V | 35 | 12 | 3.6 | 57.8 | 89.3 | 60.4 | 36.5 | 154.6 | 0.86 |
| Example 9 | $Sr_3SiO_5:Eu^{2+}$ | Mo | 6 | 21 | 1.5 | 55.6 | 86.7 | 64.2 | 40.5 | 159.1 | 0.85 |
| Comparative Example 1 | $Sr_3SiO_5:Eu^{2+}$ | - | - | - | - | 9.2 | 56.1 | 280.4 | 67.5 | 614.9 | 1.00 |
| Comparative Example 2 | $Sr_3SiO_5:Eu^{2+}$ | - | - | 9.5 | - | 29.5 | 65.4 | 240.5 | 60.2 | 350.6 | 0.85 |
| Comparative Example 3 | $Sr_3SiO_5:Eu^{2+}$ | Ti | 20 | - | - | 34.3 | 69.9 | 225.4 | 58.8 | 320.2 | 0.95 |
| Comparative Example 4 | $Sr_3SiO_5:Eu^{2+}$ | Ti | 26 | 14 | - | 45.2 | 75.5 | 200.2 | 55.3 | 289.9 | 0.84 |

INDUSTRIAL APPLICABILITY

According to the present invention, it is possible to provide a surface-treated phosphor having high dispersibility and capable of significantly enhancing moisture resistance without deteriorating the fluorescence properties, and a method for producing the surface-treated phosphor.

**Claims**

1. A surface-treated phosphor comprising:

   a phosphor body; and
   a surface treatment layer containing at least one specific element selected from elements of the third to sixth groups of the periodic table, and fluorine,
   the phosphor body having the surface treatment layer on the surface thereof,
   wherein, when a cross section of the surface treatment layer is subjected to a thickness-wise elemental analysis by a combination of an electron microscopic analysis and an energy-dispersive X-ray element analysis, a peak indicating the maximum content of the specific element appears nearer to the surface than a peak indicating the maximum fluorine content,
   wherein the surface treatment layer is a single layer, and
   fluorine is detected at the peak indicating the maximum content of the specific element in the thickness-wise elemental distribution analysis of the cross section of the surface treatment layer, wherein the phosphor body contains an alkaline earth metal.

2. The surface-treated phosphor according to claim 1, wherein the phosphor body comprises a silicate phosphor body containing an alkaline earth metal.

3. The surface-treated phosphor according to claim 1 or 2,
   wherein the phosphor body comprises a silicate phosphor body represented by the following formula (1):

$$(Sr_{1-x}M_x)_y SiO_5:Eu^{2+} \qquad (1)$$

   wherein M represents at least one metal selected from the group consisting of Ba, Ca, Mg and Zn; $0 \leq x < 1.0$; and $2.6 \leq y \text{ s } 3.3$.

4. The surface-treated phosphor according to claim 1 or 2,
   wherein the phosphor body comprises a silicate phosphor body represented by the following formula (2):

$$(Sr_{1-x}M_x)_y SiO_5:Eu^{2+}D \qquad (2)$$

   wherein M represents at least one metal selected from the group consisting of Ba, Ca, Mg and Zn; D represents a halogen anion selected from the group consisting of F, Cl, and Br; $0 \leq x < 1.0$; and $2.6 \leq y \leq 3.3$.

5. The surface-treated phosphor according to claim 1, 2 or 3,
   wherein, after 10-minute immersion of 0.1 parts by weight of the phosphor in 100 parts by weight of pure water, the water has a conductivity of not more than 100 mS/m.

6. The surface-treated phosphor according to claim 2, 3, or 4,
   wherein, after 10-minute immersion of 0.1 parts by weight of the phosphor in 100 parts by weight of pure water, an amount of eluted silicon is not more than 50 ppm.

7. The surface-treated phosphor according to claim 3 or 4,
   wherein, after 10-minute immersion of 0.1 parts by weight of the phosphor in 100 parts by weight of pure water, an amount of eluted strontium is not more than 200 ppm.

8. A phosphor-containing resin composition comprising the surface-treated phosphor according to claim 1, 2, 3, 4, 5, 6 or 7, and
   at least one of an epoxy resin and a silicone resin.

9. A wavelength conversion complex comprising the surface-treated phosphor according to claim 1, 2, 3, 4, 5, 6 or 7, and at least one resin selected from the group consisting of polyvinyl acetate, polyvinyl butyral, polyethylene, polypropylene, polymethyl methacrylate, polycarbonate, and cyclic olefin copolymer, wherein the surface-treated phosphor is dispersed in the at least one resin.

10. A wavelength conversion sheet including the wavelength conversion complex according to claim 9 formed into a sheet shape.

11. A photovoltaic device comprising the wavelength conversion complex according to claim 9 or the wavelength conversion sheet according to claim 10 as a component member.

12. A semiconductor light-emitting element comprising the surface-treated phosphor according to claim 1, 2, 3, 4, 5, 6 or 7.

13. An LED light-emitting device comprising an LED chip, a resin frame surrounding the LED chip, and a phosphor body layer filled in a concave portion formed by the resin frame, wherein the phosphor body layer includes a sealing resin and the surface-treated phosphor according to claim 1, 2, 3, 4, 5, 6 or 7.

14. The LED light-emitting device according to claim 13, which has a luminosity retention ratio of not less than 80% after energization for 1000 hours under conditions of a temperature of 60°C, a relative humidity of 90%, and a current of 20 mA.

15. The LED light-emitting device according to claim 13, which has a luminosity retention ratio of not less than 50% after being allowed to stand for 72 hours under conditions of a temperature of 121°C, and a relative humidity of 100%.

16. A backlight for a liquid crystal display element comprising the LED light-emitting device according to claim 13, 14 or 15 as a component member.

17. An image display device comprising the LED light-emitting device according to claim 13, 14 or 15 as a component member.

18. A lighting apparatus comprising the LED light-emitting device according to claim 13, 14 or 15 as a component member.

19. A method for producing the surface-treated phosphor according to claim 1, 2, 3, 4, 5, 6 or 7 comprising the step of forming the surface treatment layer by dispersing the phosphor body in a solution including a complex ion containing the specific element and fluorine to bring the phosphor body into contact with the complex ion.

20. The method for producing the surface-treated phosphor according to claim 19, wherein the complex ion containing the specific element and fluorine is $AF_6{}^{2-}$, wherein A represents at least one specific element selected from elements of the third to sixth groups of the periodic table.

21. The method for producing the surface-treated phosphor according to claim 19 or 20, wherein boric acid is further added in the step of forming the surface treatment layer.

**Patentansprüche**

1. Oberflächenbehandelter Leuchtstoff, umfassend:

    einen Leuchtstoffkörper und
    eine Oberflächenbehandlungsschicht, die wenigstens ein spezifisches Element, das aus der dritten bis sechsten Gruppe des Periodensystems ausgewählt ist, und Fluor enthält,
    wobei der Leuchtstoffkörper auf seiner Oberfläche die Oberflächenbehandlungsschicht aufweist,
    wobei, wenn ein Querschnitt der Oberflächenbehandlungsschicht einer schichtweisen Elementaranalyse mittels einer Kombination aus einer Elektronenmikroskopieanalyse und einer energiedispersiven Röntgenstrahlenelementanalyse unterzogen wird, ein Peak, der den maximalen Gehalt des spezifischen Elementes anzeigt, näher an der Oberfläche erscheint als ein Peak, der den maximalen Fluorgehalt anzeigt,

wobei die Oberflächenbehandlungsschicht eine einzelne Schicht ist und

Fluor bei dem Peak detektiert wird, der den maximalen Gehalt des spezifischen Elementes in der schichtweisen Elementarverteilungsanalyse des Querschnittes der Oberflächenbehandlungsschicht anzeigt, wobei der Leuchtstoffkörper ein Erdalkalimetall enthält.

2. Oberflächenbehandelter Leuchtstoff nach Anspruch 1,
wobei der Leuchtstoffkörper einen Silikatleuchtstoffkörper umfasst, der ein Erdalkalimetall enthält.

3. Oberflächenbehandelter Leuchtstoff nach Anspruch 1 oder 2,
wobei der Leuchtstoffkörper einen Silikatleuchtstoffkörper umfasst, der durch die folgende Formel (1) dargestellt wird:

$$(Sr_{1-x}M_x)_ySiO_5{:}Eu^{2+} \qquad (1)$$

wobei M wenigstens ein Metall darstellt, das aus der aus Ba, Ca, Mg und Zn bestehenden Gruppe ausgewählt ist, $0 \leq x\ 1{,}0$ und $2{,}6 \leq y \leq 3{,}3$.

4. Oberflächenbehandelter Leuchtstoff nach Anspruch 1 oder 2,
wobei der Leuchtstoffkörper einen Silikatleuchtstoffkörper umfasst, der durch die folgende Formel (2) dargestellt wird:

$$(Sr_{1-x}M_x)_ySiO_5{:}Eu^{2+}D \qquad (2)$$

wobei M wenigstens ein Metall darstellt, das aus der aus Ba, Ca, Mg und Zn bestehenden Gruppe ausgewählt ist, D ein Halogenanion darstellt, das aus der aus F, Cl und Br bestehenden Gruppe ausgewählt ist, $0 \leq x \leq 1{,}0$ und $2{,}6 \leq y \leq 3{,}3$.

5. Oberflächenbehandelter Leuchtstoff nach Anspruch 1, 2 oder 3,
wobei das Wasser nach 10-minütigem Eintauchen von 0,1 Gewichtsanteilen des Leuchtstoffes in 100 Gewichtsanteile reinen Wassers, eine Leitfähigkeit von nicht mehr als 100 mS/m aufweist.

6. Oberflächenbehandelter Leuchtstoff nach Anspruch 2, 3 oder 4,
wobei ein Gehalt des eluierten Siliziums nach 10-minütigem Eintauchen von 0,1 Gewichtsanteilen des Leuchtstoffes in 100 Gewichtsanteile reinen Wassers nicht mehr als 50 ppm beträgt.

7. Oberflächenbehandelte Leuchtstoff nach Anspruch 3 oder 4,
wobei ein Gehalt des eluierten Strontiums nach 10-minütigem Eintauchen von 0,1 Gewichtsanteilen des Leuchtstoffes in 100 Gewichtsanteile reinen Wassers, nicht mehr als 200 ppm beträgt.

8. Leuchtstoffhaltige Harzzusammensetzung, umfassend
den oberflächenbehandelten Leuchtstoff nach Anspruch 1, 2, 3, 4, 5, 6 oder 7 und
wenigstens eines von einem Epoxidharz und einem Silikonharz.

9. Wellenlängenkonversionskomplex, umfassend
den oberflächenbehandelten Leuchtstoff nach Anspruch 1, 2, 3, 4, 5, 6 oder 7 und
wenigstens ein Harz, das aus der aus Polyvinylacetat, Polyvinylbutyral, Polyethylen, Polypropylen, Polymethylmethacrylat, Polycarbonat und cyclischem Olefincopolymer bestehenden Gruppe ausgewählt ist,
wobei der oberflächenbehandelte Leuchtstoff in dem wenigstens einen Harz dispergiert ist.

10. Wellenlängenkonversionsbogen, umfassend den Wellenlängenkonversionskomplex nach Anspruch 9, der in eine Bogenform ausgebildet ist.

11. Photovoltaikanlage, umfassend den Wellenlängenkonversionskomplex nach Anspruch 9 oder den Wellenlängenkonversionsbogen nach Anspruch 10 als ein Komponentenelement.

12. Lichtemittierendes Halbleiterelement, umfassend den oberflächenbehandelten Leuchtstoff nach Anspruch 1, 2, 3, 4, 5, 6 oder 7.

13. LED-lichtemittierende Vorrichtung, umfassend
einen LED-Chip

EP 2 554 628 B1

einen den LED-Chip umgebenden Harzrahmen und

eine Leuchtstoffkörperschicht, die in einen durch den Harzrahmen gebildeten konkaven Abschnitt gefüllt ist, wobei die Leuchtstoffkörperschicht ein Versiegelungsharz und den oberflächenbehandelten Leuchtstoff nach Anspruch 1, 2, 3, 4, 5, 6 oder 7 umfasst.

14. LED-lichtemittierende Vorrichtung nach Anspruch 13, die ein Leuchtkraftbeibehaltungsverhältnis von nicht weniger als 80 % nach einer Bestromung für 1000 Stunden unter Bedingungen von einer Temperatur von 60 °C, einer relativen Feuchtigkeit von 90 % und einer Stromstärke von 20 mA aufweist.

15. LED-lichtemittierende Vorrichtung nach Anspruch 13, die ein Leuchtkraftbeibehaltungsverhältnis von nicht weniger als 50 % aufweist, nachdem sie für 72 Stunden unter Bedingungen von einer Temperatur von 121 °C und einer relativen Feuchtigkeit von 100 % betrieben wurde.

16. Hintergrundlicht für ein Flüssigkristallanzeigenelement, umfassend die LEDlichtemittierende Vorrichtung nach Anspruch 13, 14 oder 15 als ein Komponentenelement.

17. Bildanzeigevorrichtung, umfassend die LED-lichtemittierende Vorrichtung nach Anspruch 13, 14 oder 15 als ein Komponentenelement.

18. Belichtungsvorrichtung, umfassend die LED-lichtemittierende Vorrichtung nach Anspruch 13, 14 oder 15 als ein Komponentenelement.

19. Verfahren zum Herstellen des oberflächenbehandelten Leuchtstoffs nach Anspruch 1, 2, 3, 4, 5, 6 oder 7, umfassend den Schritt des

Ausbildens der Oberflächenbehandlungsschicht mittels Dispergierens des Leuchtstoffkörpers in einer Lösung, die ein Komplexion umfasst, das das spezifische Element und Fluor enthält, um den Leuchtstoffkörper mit dem Komplexion in Kontakt zu bringen.

20. Verfahren zum Herstellen des oberflächenbehandelten Leuchtstoffkörpers nach Anspruch 19,

wobei das Komplexion, das das spezifische Element und Fluor enthält, $AF_6^{2-}$ ist, wobei A wenigstens ein spezifisches Element darstellt, das aus Elementen der dritten bis sechsten Gruppe des Periodensystems ausgewählt ist.

21. Verfahren zum Herstellen des oberflächenbehandelten Leuchtstoffes nach Anspruch 19 oder 20,

wobei ferner Borsäure im Schritt des Ausbildens der Oberflächenbehandlungsschicht hinzugefügt wird.

## Revendications

1. Luminophore traité en surface comprenant :

un corps de luminophore ; et
une couche de traitement de surface contenant au moins un élément spécifique choisi parmi des éléments des troisième à sixième groupes de la classification périodique des éléments, et du fluor,
le corps de luminophore présentant la couche de traitement de surface sur la surface de celui-ci,
dans lequel, lorsqu'une section transversale de la couche de traitement de surface est soumise à une analyse élémentaire dans le sens de l'épaisseur par une combinaison d'une analyse microscopique électronique et d'une analyse d'éléments aux rayons X à énergie dispersive, un pic indiquant la teneur maximale de l'élément spécifique apparait plus à proximité de la surface qu'un pic indiquant la teneur maximale en fluor,
dans lequel la couche de traitement de surface est une seule couche, et
du fluor est détecté au pic indiquant la teneur maximale de l'élément spécifique dans l'analyse de distribution élémentaire dans le sens de l'épaisseur de la section transversale de la couche de traitement de surface, dans lequel le corps de luminophore contient un métal alcalino-terreux.

2. Luminophore traité en surface selon la revendication 1, dans lequel le corps de luminophore comprend un corps de luminophore de silicate contenant un métal alcalino-terreux.

3. Luminophore traité en surface selon la revendication 1 ou 2, dans lequel le corps de luminophore comprend un corps de luminophore de silicate représenté par la formule (1) suivante :

$$(Sr_{1-x}M_x)_y SiO_5 : Eu^{2+} \qquad (1)$$

où M représente au moins un métal choisi dans le groupe constitué de Ba, Ca, Mg et Zn ; $0 \leq x < 1,0$ ; et $2,6 \leq x \leq 3,3$.

**4.** Luminophore traité en surface selon la revendication 1 ou 2, dans lequel le corps de luminophore comprend un corps de luminophore de silicate représenté par la formule (2) suivante :

$$(Sr_{1-x}M_x)_y SiO_5 : Eu^{2+}D \qquad (2)$$

où M représente au moins un métal choisi dans le groupe constitué de Ba, Ca, Mg et Zn ; D représente un anion d'halogène choisi dans le groupe constitué de F, Cl, et Br ; $0 \leq x < 1,0$ ; et $2,6 \leq y \leq 3,3$.

**5.** Luminophore traité en surface selon la revendication 1, 2 ou 3, dans lequel, après une immersion de 10 minutes de 0,1 partie en masse du luminophore dans 100 parties en masse d'eau pure, l'eau présente une conductivité d'au plus 100 mS/m.

**6.** Luminophore traité en surface selon la revendication 2, 3, ou 4, dans lequel, après une immersion de 10 minutes de 0,1 partie en masse du luminophore dans 100 parties en masse d'eau pure, une quantité de silicium élué est d'au plus 50 ppm.

**7.** Luminophore traité en surface selon la revendication 3 ou 4, dans lequel, après une immersion de 10 minutes de 0,1 partie en masse du luminophore dans 100 parties en masse d'eau pure, une quantité de strontium élué est d'au plus 200 ppm.

**8.** Composition de résine contenant un luminophore comprenant le luminophore traité en surface selon la revendication 1, 2, 3, 4, 5, 6 ou 7, et
au moins une d'une résine époxy et d'une résine de silicone.

**9.** Complexe de conversion de longueur d'onde comprenant
le luminophore traité en surface selon la revendication 1, 2, 3, 4, 5, 6 ou 7, et
au moins une résine choisie dans le groupe constitué de poly(acétate de vinyle), polyvinylbutyral, polyéthylène, polypropylène, poly(méthacrylate de méthyle), polycarbonate, et un copolymère d'oléfine cyclique,
dans lequel le luminophore traité en surface est dispersé dans la au moins une résine.

**10.** Feuille de conversion de longueur d'onde comprenant le complexe de conversion de longueur d'onde selon la revendication 9 formé dans une forme de feuille.

**11.** Dispositif photovoltaïque comprenant le complexe de conversion de longueur d'onde selon la revendication 9 ou la feuille de conversion de longueur d'onde selon la revendication 10 comme un élément de constituant.

**12.** Elément émettant de la lumière à semiconducteur comprenant le luminophore traité en surface selon la revendication 1, 2, 3, 4, 5, 6 ou 7.

**13.** Dispositif émettant de la lumière LED comprenant une pastille LED,
un cadre de résine entourant la pastille LED, et
une couche de corps de luminophore introduite dans une portion concave formée par le cadre de résine,
dans lequel la couche de corps de luminophore comprend une résine de scellement et le luminophore traité en surface selon la revendication 1, 2, 3, 4, 5, 6 ou 7.

**14.** Dispositif émettant de la lumière LED selon la revendication 13, lequel présente un rapport de rétention de luminosité d'au moins 80 % après mise sous tension pendant 1 000 heures dans des conditions d'une température de 60°C, d'une humidité relative de 90 %, et d'un courant de 20 mA.

**15.** Dispositif émettant de la lumière LED selon la revendication 13, lequel présente un rapport de rétention de luminosité d'au moins 50 % après avoir été laissé pendant 72 heures dans des conditions d'une température de 121°C, et d'une humidité relative de 100 %.

**16.** Rétroéclairage pour un élément d'affichage à cristaux liquides comprenant le dispositif émettant de la lumière LED selon la revendication 13, 14 ou 15 comme un élément constituant.

**17.** Dispositif d'affichage d'image comprenant le dispositif émettant de la lumière LED selon la revendication 13, 14 ou 15 comme un élément constituant.

**18.** Appareil d'éclairage comprenant le dispositif émettant de la lumière LED selon la revendication 13, 14 ou 15 comme un élément constituant.

**19.** Procédé de production du luminophore traité en surface selon la revendication 1, 2, 3, 4, 5, 6 ou 7 comprenant l'étape de formation de la couche de traitement de surface par dispersion du corps de luminophore dans une solution comprenant un ion complexe contenant l'élément spécifique et du fluor pour mettre le corps de luminophore en contact avec l'ion complexe.

**20.** Procédé de production du luminophore traité en surface selon la revendication 19, dans lequel l'ion complexe contenant l'élément spécifique et du fluor est $AF_6^{2-}$, où A représente au moins un élément spécifique choisi parmi des éléments des troisième à sixième groupes de la classification périodique des éléments.

**21.** Procédé de production du luminophore traité en surface selon la revendication 19 ou 20, dans lequel de l'acide borique est encore ajouté dans l'étape de formation de la couche de traitement de surface.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

200 nm

Fig. 19

Fig. 20

Fig. 21

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009515030 A
- JP 2009515030 T
- JP 9104863 A
- JP 2001139941 A
- JP 2009524736 A
- JP 2009524736 T
- JP 2008111080 A
- JP 2007224262 A
- JP 2009132902 A
- JP HEI11256150 B
- JP H11256150 A
- JP 2006232949 B